# EUROPÄISCHE PATENTSCHRIFT

(11) **EP 0 985 252 B1**
(45) Veröffentlichungstag und Bekanntmachung des Hinweises auf die Patenterteilung: **16.01.2002**
(21) Anmeldenummer: 98932049.4
(22) Anmeldetag: 04.05.1998
(51) Int. Cl.: H01R 13/633, G06K 13/08, G11B 17/04, G11B 33/12

(54) **AUSWURFMECHANISMUS FÜR IN SCHLITZARTIGE VERTIEFUNGEN EINES GEHÄUSES EINSETZBARE STECK-BAUGRUPPEN**
EJECTING MECHANISM FOR EJECTION OF PLUG-IN MODULES PLUGGED IN SLOT-SHAPED LOWS OF A HOUSING
MECANISME D'EJECTION POUR MODULES ENFICHABLES DANS DES DEPRESSIONS EN FORME DE FENTES DANS UN BOITIER

(30) Priorität: 27.05.1997 DE 19722126
(43) Veröffentlichungstag der Anmeldung: 15.03.2000
(73) Patentinhaber: Fujitsu Siemens Computers GmbH, 81739 München (DE)
(72) Erfinder: REICH, Henning, D-86359 Stadtbergen (DE); DELLO BUONO, Silvio, I-83020 Cesinali (IT)
(74) Vertreter: Epping, Wilhelm, Dipl.-Ing.
(86) Internationale Anmeldenummer: DE9801222
(87) Internationale Veröffentlichungsnummer: WO9854795

(56) Entgegenhaltungen:
- EP-A- 0 385 750
- EP-A- 0 607 848
- WO-A-97/10691
- US-A- 5 179 505
- US-A- 5 179 871
- US-A- 5 384 686
- US-A- 5 684 655

## Beschreibung

Die Erfindung betrifft einen Auswurfmechanismus nach den Merkmalen des Oberbegriffs des Anspruchs 1. Ein derartiger Auswurfmechanismus ist im Prinzip aus US 5,179,871 und EP 0 607 848 A2 bekannt.

Bei elektronischen Geräten, insbesondere im Bereich der Computertechnik, setzt sich zunehmend eine Bauweise durch, bei ein einzelne Komponenten über von außen zugängliche Einbauplätze und dort vorgesehene Steckkontakte angeschlossen werden können. Der Ein- und Ausbau soll dabei einfach und möglichst ohne Werkzeug möglich sein. Während das Einstecken noch relativ einfach durchführbar ist, bereitet der Ausbau nicht selten Probleme, weil die eingeschobenen Komponenten entweder zur Gänze in das Gehäuse eintauchen oder allenfalls geringfügig vorstehen, so daß sie von Hand nicht oder nur sehr schwierig herausgezogen werden können. Aus diesem Grund ist bei einer Vielzahl von Geräten, insbesondere bei tragbaren Computern, wie Notebooks oder dergleichen, eine Auswurfmechanismus vorgesehen, mit dessen Hilfe durch Betätigung einer Drucktaste die Entnahme einer Steck-Baugruppe erleichtert werden kann. Beispiele hierfür sind u. a. PCMCIA-Einbauplätze in Notebooks, CD-ROM-, Floppydisk-Laufwerke, Festplatten oder dergleichen. Dabei sollten im Prinzip folgende Randbedingungen eingehalten werden:
- Die Drucktaste für den Auswurfmechanismus soll einerseits nicht weit aus dem Gehäuse herausragen, um ein störendes Verhaken und ggf. Abbrechen des Druckknopfs zu vermeiden. Andererseits soll die Drucktaste aus Gründen der Ergonomie und des meist geringer Platzangebots nicht sehr tief in das Gehäuse eintauchen.
- Die Steck-Baugruppe soll mit Hilfe des Auswurfmechanismus möglichst weit aus dem Gerät herauskommen, damit sie vom Benutzer leicht entnommen werden kann.
- Aus ergonomischen Gründen soll die Druckkraft auf die Drucktaste möglichst klein sein.
- Der Aufwand für den Auswurfmechanismus soll gering sein.

Bei den eingangs erwähnten bekannten Auswurfmechanismen nach US 5,179,871 und EP 0 607 848 A2, werden die vorstehend genannten Bedingungen insoweit erfüllt, als das Hebelverhältnis des zweiarmigen Hebels durch Verlagerung der Drehachse von einem langen ersten und kurzem zweiten Hebelarm zu einem kurzen ersten und langem zweiten Hebelarm wechselt. Dies führt in der zweiten Auswurfphase zu einem relativ großen Hebelausschlag, auch auf der Seite des dem Stößel zugeordneten ersten Hebelarms mit der Folge eines entsprechend großen Stößelhubes.

Der vorliegenden Erfindung liegt deshalb die Aufgabe zugrunde, einen Auswurfmechanismus der im Oberbegriff des Anspruchs 1 genannten Art in der Weise zu verbessern, daß er für den Benutzer eine sowohl einfache, als auch ergonomisch vorteilhafte Benutzung mit vergleichsweise geringen Hebelbewegungen ermöglicht.

Die Lösung dieser Aufgabe ergibt sich erfindungsgemäß durch die Merkmale des Patentanspruchs 1. Der Vorteil der erfindungsgemäßen Vorrichtung besteht darin, dass die Änderung des Hebelverhältnisses für den zweiarmigen Hebel nicht durch eine Verlagerung der Hebeldrehachse, sondern unter Beibehaltung der Hebeldrehachse durch eine einfache Verkürzung des ersten Hebelarms mit Hilfe der in Richtung der Hebeldrehachse bis in deren Nähe reichende Querkomponente des Stößels erreicht wird. Vorteilhafte Weiterbildungen der Erfindung sind in Unteransprüchen angegeben.

Im folgenden wird ein Ausführungsbeispiel der Erfindung anhand der Zeichnungen näher erläutert. Dabei zeigen:
- FIG 1: den Auswurfmechanismus gemäß der Erfindung in Ruhestellung
- FIG 2: die Anordnung gemäß FIG 1 in einem ersten Arbeitsschritt
- FIG 3: die Anordnung gemäß FIG 1 in einem zweiten Arbeitsschritt

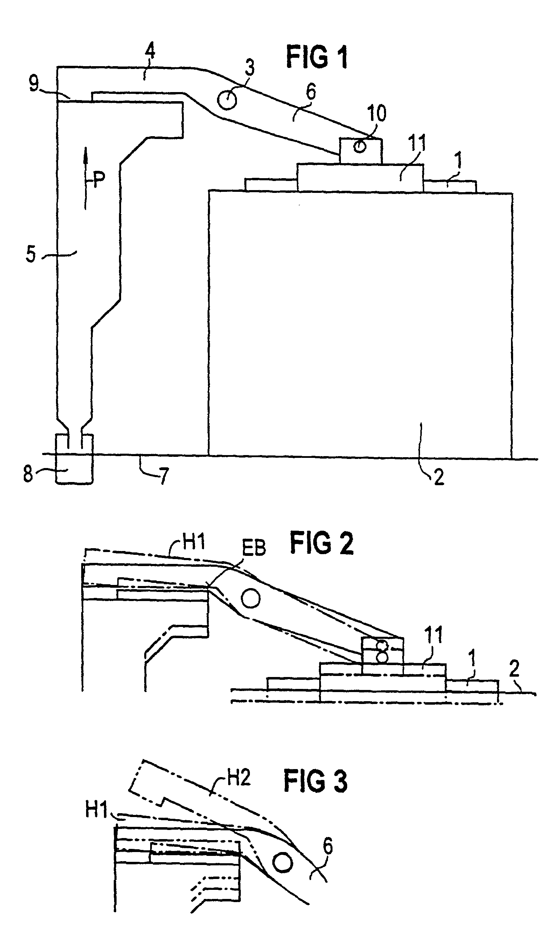

Die FIG 1 zeigt das Prinzip eines Auswurfmechanismus für eine in eine schlitzartige Vertiefung eines Gehäuses von außen einsteckbare und an einem Mehrfachstecker 1 anschließbare Steck-Baugruppe 2, beispielsweise Festplatten-, Floppydisk-, CD-ROM-Laufwerke oder PC-Steckkarten. Der Auwurfmechanismus besteht aus einem zweiarmigen, um eine Drehachse 3 schwenkbar gelagerten Hebel, dessen erster Hebelarm 4 einem Stößel 5 und dessen zweiter, etwa gleichlanger Hebelarm 6 der Steck-Baugruppe 2 zugeordnet ist. Zur Betätigung des Stößels 5 dient eine aus der Gehäusewandung 7 geringfügig vorstehende Drucktaste 8. Am gegenüberliegende Ende des Stößels 5, das heißt an dem dem ersten Hebelarm 4 zugewandten Ende, weist der Stößel 5 eine vom freien Hebelende bis in die Nähe der Hebeldrehachse 3 reichende Querkomponente auf. Darüber hinaus ist der am freien Ende des ersten Hebelarms 4 vorgesehene Berührungsbereich zwischen Hebelarm 4 und Stößel 5 durch einen nasenartigen Vorsprung 9 am Hebelarm 4 und/oder am Stößel 5 so geformt, daß sich in der Ruhestellung des Hebels im Bereich der Drehachse 3 ein etwa den Abmessungen des nasenartigen Vorsprungs 9 entsprechender Abstand zwischen erstem Hebelarm 4 und Stößel 5 ergibt. Am freien Ende des zweiten Hebelarms 6 ist ein über ein Drehgelenk 10 angekoppelter Stempel 11 vorgesehen, der das eigentliche Auswurfelement bildet und der sich an der Rückkante der Steck-Baugruppe 2, parallel zum Mehrfachstecker 1 verlaufend, abstützt.

Der anhand FIG 1 im einzelnen dargestellte und beschriebene Auswurfmechanismus wird nun im folgenden mit Hilfe der in den FIG 2 und 3 dargestellten Arbeitsschritte näher erläutert. Durch Drücken der Drucktaste 8 wird der Stößel in Pfeilrichtung P bewegt, wobei der Stößel 5 den Druck im Bereich des am freien Ende des ersten Hebelarms 4 vorgesehenen nasenartigen Vorsprungs 9 an den Hebel weitergibt. Aufgrund der relativ geringen Hebelübersetzung genügt schon ein leichter Druck auf die Drucktaste 8, um die hohen Steckkräfte des Mehrfachstekkers 1 zu überwinden und die Baugruppe 2 vom Mehrfachstecker 1 zu lösen. In dieser ersten Hebelphase H1 (siehe die strichpunktiert gezeichnete Hebestellung in FIG 2) findet nur eine relativ geringe Hebelbewegung statt und zwar nur so weit, bis der Stößel 5 mit seinem bis in die Nähe der Hebeldrehachse 3 erreichenden Endbereich EB seiner Querkomponente unter Bildung eines entsprechend kürzeren Hebelarms gegen den ersten Hebelarm 4 drückt.

Mit dem dadurch bedingten Wechsel des Übersetzungsverhältnisses wird beim weiteren Nachdrücken der Drucktaste 8 bzw. des Stößels 5 aufgrund des nunmehr kürzeren ersten Hebelarms 4 erreicht, daß in der zweiten Hebelphase H2 (siehe insbesondere FIG 3) bei geringem Hub auf Seiten des ersten Hebelarms 4 ein vergleichsweise langer Hub auf Seiten des zweiten Hebelarms 6 stattfindet mit der Folge, daß die Steck-Baugruppe 2 letztlich sehr weit ausgeworfen werden kann.

Aus Platzgründen kann es zweckmäßig sein, wenn der Hebel im Nahbereich der Hebeldrehachse 3 eine Kröpfung aufweist und der erste Hebelarm 4 zusammen mit Stößel 5 und Drucktaste 8 auf der einen Seite und der zweite Hebelarm 6 auf der anderen Seite einer auf dieser Seite auch die Steck-Baugruppe 2 aufnehmenden Trägerplatine angeordnet sind.

## Patentansprüche

1. Auswurfmechanismus für in schlitzartige Vertiefungen eines Gehäuses einsetzbare Steck-Baugruppen (2), unter Verwendung eines mittels eines Stößels (5) betätigbaren zweiarmigen Hebels, der bei Betätigung des auf den ersten Hebelarm (4) einwirkenden Stößels mit Hilfe des dem steckerseitigen Ende der Steck-Baugruppe räumlich zugeordneten zweiten Hebelarms (6) eine Loslösung des Steckkontakts und eine Auswurfbewegung der Steck-Baugruppe in der Weise bewirkt, daß der Stößel (5) in einer ersten Hebelphase (H1) an einem langen Hebelarm und in einer zweiten Hebelphase (H2) an einem kurzen Hebelarm ansetzt,
**dadurch gekennzeichnet,**
**daß** das dem ersten Hebelarm (4) zugewandte Ende des Stößels (5) eine vom freien Ende des ersten Hebelarms (4) bis in die Nähe der Hebeldrehachse (3) reichende Querkomponente aufweist, welche in der zweiten Hebelphase (H₂) unter Bildung eines entsprechend kürzeren Hebelarms gegen den ersten Hebelarm (4) drückt.

2. Auswurfmechanismus nach Anspruch 1,
**dadurch gekennzeichnet,**
**daß** am Stößel (5) und/oder am ersten Hebelarm (4) in dem die erste Hebelphase (H1) auslösenden Berührungsbereich zwischen Stößel (5) und ersten Hebelarm (4) ein wenigstens der Wegstecke der ersten Hebelphase entsprechender nasenartiger Vorsprung (9) vorgesehen ist.

3. Auswurfmechanismus nach Anspruch 1 oder 2,
**dadurch gekennzeichnet,**
**daß** der Hebel im Bereich der Hebelachse (3) eine Kröpfung aufweist derart, daß der erste Hebelarm (4) einschließlich des Stößels (5) auf der einen Seite und der zweite Hebelarm (6) auf der anderen Seite einer auf dieser Seite auch die Steck-Baugruppe (2) aufnehmenden Trägerplatine angeordnet ist.

4. Auswurfmechanismus nach einem der vorhergehenden Ansprüche,
**dadurch gekennzeichnet,**
**daß** am freien Ende des zweiten Hebelarms (6) ein drehbar gelagerter Stempel (11) vorgesehen ist.

## Claims

1. Ejecting mechanism for plug-in modules (2) which can be inserted into slot-like depressions of a housing, using a two-armed lever which can be actuated by means of a push rod (5) and, on actuation of the push rod acting on the first lever arm (4), uses the second lever arm (6) spatially assigned to the plug-side end of the plug-in module to bring about a release of the plug-in contact and an ejecting movement of the plug-in module in such a way that the push rod (5) acts in a first lever phase (H1) on a long lever arm and in a second lever phase (H2) on a short lever arm, **characterized in that** the end of the push rod (5) facing the first lever arm (4) has a transverse component reaching from the free end of the first lever arm (4) into the proximity of the lever pivot axis (3), which in the second lever phase (H2) presses against the first lever arm (4), thereby forming a correspondingly shorter lever arm.

2. Ejecting mechanism according to Claim 1, **characterized in that** a nose-like projection (9) corresponding at least to the distance covered in the first lever phase is provided on the push rod (5) and/or on the first lever arm (4) in the region of contact between push rod (5) and first lever arm (4) initiating the first lever phase (H1).

3. Ejecting mechanism according to Claim 1 or 2, **characterized in that** the lever has a crank in the region of the lever axis (3) in such a way that the first lever arm (4), including the push rod (5), is arranged on one side and the second lever arm (6) is arranged on the other side of a mounting board also accommodating the plug-in module (2) on this side.

4. Ejecting mechanism according to one of the preceding claims, **characterized in that** a pivotably mounted plunger (11) is provided at the free end of the second lever arm (6).

## Revendications

1. Mécanisme d'éjection pour modules (2) enfichables dans des dépressions en forme de fentes d'un boîtier, utilisant un levier à deux bras qui peut être actionné au moyen d'un poussoir (5) et qui, lorsqu'on actionne le poussoir agissant sur le premier bras (4) de levier, produit, à l'aide du deuxième bras (6) de levier spatialement associé à l'extrémité côté fiche du module enfichable, un désengagement de la liaison enfichable et un mouvement d'éjection du module enfichable de telle sorte que le poussoir (5) s'applique dans une première phase (H1) de levier sur un bras de levier long et dans une deuxième phase (H2) de levier sur un bras de levier court,
**caractérisé en ce que** l'extrémité du poussoir (5) qui est tournée vers le premier bras (4) de levier comporte un élément transversal qui s'étend depuis l'extrémité libre du premier bras (4) de levier jusqu'à proximité de l'axe (3) de rotation du levier et qui, dans la deuxième phase (H2) de levier, s'appuie contre le premier bras (4) de levier en formant un bras de levier plus court correspondant.

2. Mécanisme d'éjection suivant la revendication 1, **caractérisé en ce qu'**il est prévu sur le poussoir (5) et/ou sur le premier bras (4) de levier, dans la région de contact entre le poussoir (5) et le premier bras (4) de levier qui déclenche la première phase (H1) de levier, une saillie (9) du genre bec correspondant au moins à la course de la première phase de levier.

3. Mécanisme d'éjection suivant la revendication 1 ou 2, **caractérisé en ce que** le levier comporte, dans la région de l'axe (3) de rotation du levier, un contre-coudage de telle sorte que le premier bras (4) de levier, poussoir (5) compris, est disposé d'un côté, et le deuxième bras (6) de levier de l'autre côté, d'une platine porteuse qui reçoit également, sur cet autre côté, le module (2) enfichable.

4. Mécanisme d'éjection suivant l'une des revendications précédentes, **caractérisé en ce qu'**un presseur (11) monté à rotation est prévu à l'extrémité libre du deuxième bras (6) de levier.
